**Europäisches Patentamt**

**European Patent Office**

**Office européen des brevets**

(19)

(11) Veröffentlichungsnummer: **0 461 289 A1**

## (12) EUROPÄISCHE PATENTANMELDUNG

(21) Anmeldenummer: **90111222.7**

(22) Anmeldetag: **13.06.90**

(51) Int. Cl.⁵: **C23F 1/08**, H05K 3/06

(43) Veröffentlichungstag der Anmeldung:
**18.12.91 Patentblatt 91/51**

(84) Benannte Vertragsstaaten:
**DE FR GB IT**

(71) Anmelder: **SIEMENS AKTIENGESELLSCHAFT**

Wittelsbacherplatz 2
W-8000 München 2(DE)

(72) Erfinder: **Hosten, Daniel**
Staatsbaan 147
B-8120 Handzame(BE)

(54) **Vorrichtung zum Behandeln von dreidimensionalen Werkstücken mit einer Flüssigkeit.**

(57) Die Vorrichtung umfaßt:
- eine Behandlungskammer (B) mit Düsenstökken zum Besprühen der Werkstücke (W),
- Werkstückträger (Wt) zur Aufnahme von Werkstücken (W) und
- eine Transporteinrichtung (T) zum taktweisen Transport der Werkstückträger (W), wobei
- die Werkstückträger (W) zum Ablauf der Flüssigkeit (F) drehbar und zum Abschleudern verbliebener Flüssigkeitsreste mit einer Schleuder- und/oder Schlagbewegung beaufschlagbar sind.

Die erfindungsgemäße Vorrichtung ist insbesondere für das Ätzen von dreidimensionalen Spritzgießteilen mit integrierten Leiterzügen geeignet, wobei durch den Ablauf und das Abschleudern eine Verschleppung der Ätzlösung weitgehend verhindert wird.

FIG 1

EP 0 461 289 A1

Die Erfindung betrifft eine Vorrichtung zum Behandeln von dreidimensionalen Werkstücken mit einer Flüssigkeit, insbesondere zum Ätzen von dreidimensionalen Spritzgießteilen mit integrierten Leiterzügen.

Bei der Herstellung von Leiterplatten, deren Leiterzüge bei einem vorausgegangen Galvanoprozeß mit Metallresist, wie Reinzinn oder Bleizinn abgedeckt worden sind, erfolgt die Erzeugung des Leiterbildes durch Ätzen meist in horizontalen Durchlaufanlagen. Als Transporteinrichtung für einen kontinuierlichen Transport der Leiterplatten durch die Ätzkammer werden angetriebene Walzen eingesetzt, wobei am Eingang und Ausgang der Ätzkammer angeordnete Quetschwalzenpaare eine Austragung der Ätzlösung weitgehend verhindern. Zum Aufbringen der Ätzlösung auf die Leiterplatten befinden sich innerhalb der Ätzkammer oszillierende Düsenstöcke, aus deren Sprühdüsen die Ätzlösung von oben und von unten gegen die in horizontaler Richtung durchlaufenden Leiterplatten gsprüht wird. Nach dem Ätzen durchlaufen die Leiterplatten mehrere Spülvorrichtugnen, die ebenfalls als horizontale Durchlaufanlagen mit oberhalb und unterhalb der Transporteinrichtung angeordneten Sprühdüsen ausgebildet sind.

Bei der Herstellung von dreidimensionalen Spritzgießteilen mit integrierten Leiterzügen können die für ebene Leiterplatten entwickelten Ätz- und Spülvorrichtungen aus mehreren Gründen nicht eingesetzt werden. So ist das Transportsystem dieser Vorrichtungen für den Transport von dreidimensionalen Spritzgießteilen nicht geeignet, wobei insbesondere auch der eingangsseitige und ausgangsseitige Abschluß der Behandlungskammern durch Quetschwalzenpaare entfallen muß. Ein gleichmäßiges Ätzen der dreidimensionalen Spritzgießteile durch oberhalb und unterhalb einer horizontalen Durchlaufbahn angeordnete Sprühdüsen ist ebenfalls nicht möglich. Die größten Probleme bereitet jedoch die Verschleppung von Ätz- und Spüllösung, die sich in Hohlräumen, Taschen und Nischen der dreidimensionalen Werkstücke ansammelt. So ist die Verschleppung von Ätzlösung aus der Ätzkammer durch die Spritzgießteile so groß, daß eine geregelte Badführung nicht mehr möglich ist. Außerdem führt die starke Verschleppung der Ätzlösung zu einer entsprechenden Belastung des Spülwassers und damit zu erheblichen Problemen bei der Abwasseraufbereitung.

Der Erfindung liegt die Aufgabe zugrunde, eine Vorrichtung zum Behandeln von dreidimensionalen Werkstücken mit einer Flüssigkeit zu schaffen, bei welcher ein Austragen der verwendeten Flüssigkeit weitgehend verhindert wird. Außerdem soll bei einer Ätzbehandlung der Werkstücke ein kontrolliertes, gleichmäßiges Ätzen ermöglicht werden.

Die Lösung dieser Aufgabe erfolgt durch eine Vorrichtung zum Behandeln von dreidimensionalen Werkstücken mit einer Flüssigkeit, insbesondere zum Ätzen von dreidimensionalen Spritzgießteilen mit integrierten Leiterzügen, mit

- mindestens einer Behandlungskammer, welche mit Düsenstöcken zum Besprühen der Werkstücke mit der Flüssigkeit bestückt ist,
- Werkstückträgern zur Aufnahme mindestens eines Werkstücks und mit
- einer Transporteinrichtung zum taktweisen Transport der Werkstückträger in und durch die Behandlungskammer in einer horizontalen Transportrichtung, wobei
- die Werkstückträger zum Ablauf der Flüssigkeit von den Werkstücken um eine horizontal und quer zur Transportrichtung ausgerichtete Achse drehbar und zum Abschleudern auf den Werkstücken verbliebener Flüssigkeitsreste mit einer Schleuder- und/oder Schlagbewegung beaufschlagbar sind.

Bei der erfindungsgemäßen Vorrichtung werden für den Transport der Werkstücke also Werkstückträger eingesetzt, die mit der Transporteinrichtung zunächst in die Behandlungskammern eingebracht werden und erst nach Abschluß der jeweiligen Behandlung wieder hinaustransportiert werden. Der diskontinuierliche Transport der Werkstücke ermöglicht dabei einen eingangsseitigen und ausgangsseitigen Abschluß der Behandlungskammern. Innerhalb der jeweiligen Behandlungskammer können die Werkstückträger nach der Behandlung um eine horizontal und quer zur Transportrichtung ausgerichtete Achse dann so gedreht werden, daß die in den Werkstücken verbliebene Flüssigkeit ablaufen kann. Die nach diesem Ablaufen noch auf den Werkstücken verbliebenen Flüssigkeitsreste werden dann ebenfalls mit Hilfe der Werkstückträger weitgehend abgeschleudert. Dieses Abschleudern erfolgt durch eine Schleuderbewegung der Werkstückträger oder durch eine auf die Werkstückträger einwirkende Schlagbewegung, wobei Schleuder- und Schlagbewegung auch kombiniert eingesetzt werden können.

Der diskontinuierliche Transport der Werkstücke kann mit besonders geringem Aufwand dadurch realisiert werden, daß die Transporteinrichtung beidseitig des Transportweges angeordnete und in Transportrichtung hin- und herbewegbare Transportstangen und auf den Transportstangen angeordnete Mitnehmer für die Werkstückträger umfaßt.

Gemäß einer weiteren bevorzugten Ausgestaltung der erfindungsgemäßen Vorrichtung ist die Behandlungskammer ein- und austrittsseitig durch Schiebe- oder Schwenktüren verschließbar. Durch diese Schiebe- oder Schwenktüren kann dann insbesondere im Fall der Ätzbehandlung ein Austritt von Ätzmitteldämpfen aus der Ätzkammer sicher ausgeschlossen werden.

Erfolgt die Entfernung der nach dem Ablaufen auf den Werkstücken verbliebenen Flüssigkeitsreste durch eine Schleuderbewegung, so kann dies auf besonders einfache Weise durch eine Schleuderbewegung um die Achse der Werkstückträger realisiert werden.

Ein Abschleudern der nach dem Ablauf der Flüssigkeit auf den Werkstücken verbliebenen Flüssigkeitsreste ist dann besonders effektiv, wenn die Werkstückträger durch beidseitig des Transportweges angeordnete Klopfeinrichtungen mit der Schlagbewegung beaufschlagbar sind. Die Klopfeinrichtungen sind dabei vorzugsweise jeweils durch ein Führungsteil für den Werkstückträger und einen auf das Führungsteil einwirkenden Nokken gebildet. Die Wirkung dieser Klopfeinrichtungen kann dann zusätzlich noch dadurch weiter verbessert werden, daß das Führungsteil durch den Nocken gegen die Kraft einer Feder anhebbar ist. Eine weitere Vereinfachung der Konstruktion wird dadurch erreicht, daß eines der Führungsteile als Mitnehmer für die Drehung des Werkstückträgers ausgebildet ist.

Im Hinblick auf ein möglichst gleichmäßiges Ätzen bei minimalen Unterätzungen ist es besonders günstig, wenn die Düsenstöcke horizontal und quer zur Transportrichtung ausgerichtet sind. Die Düsenstöcke können dabei eine oszillierende Längsbewegung und/oder eine oszillierende Schwenkbewegung um ihre Längsachse ausführen.

Ein Ausführungsbeispiel der Erfindung ist in der Zeichnung dargestellt und im folgenden näher beschrieben.

Es zeigen

FIG 1    eine Vorrichtung zum Ätzen von dreidimensionalen Spritzgießteilen mit integrierten Leiterzügen in teilweise aufgebrochener, perspektivischer Darstellung und

FIG 2    das Prinzip einer Klopfeinrichtung zum Abschleudern der auf den Spritzgießteilen verbliebenen Ätzlösung.

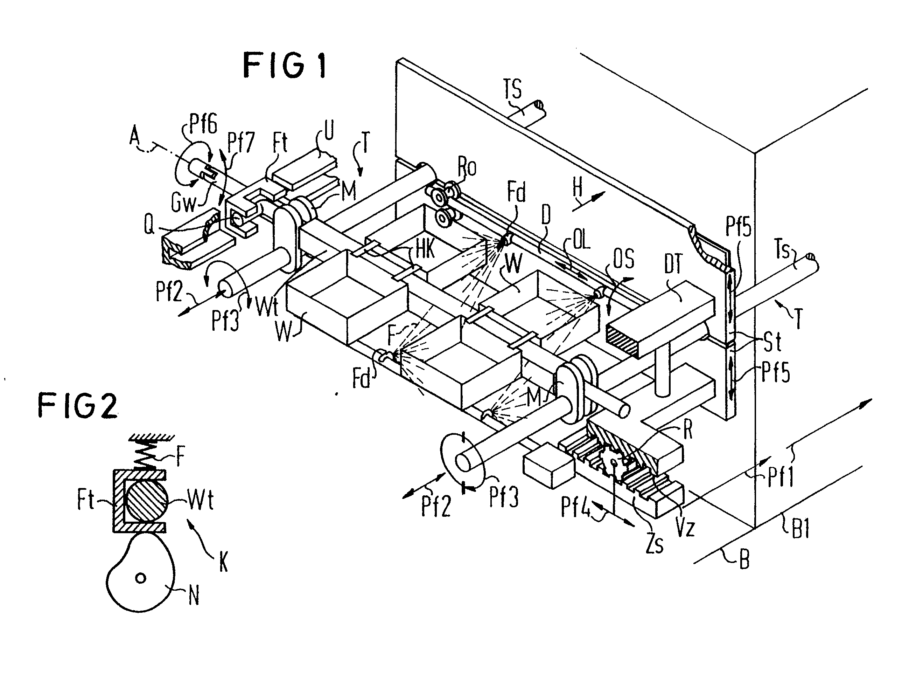

FIG 1 zeigt in stark vereinfachter Darstellung einen Ausschnitt aus einer ammoniakalischen Ätzlinie für dreidimensionale Werkstücke W, welche in einer horizontalen Transportrichtung H durch Behandlungskammern B und B1 geführt werden. Bei der in FIG 1 im Vordergrund aufgebrochen dargestellten Behandlungskammer B handelt es sich um eine Ätzkammer, während es sich bei der anschließenden Behandlungskammer B1 beispielsweise um eine Spülkammer handelt.

Bei den Werkstücken W handelt es sich um dreidimensionale Spritzgießteile mit integrierten Leiterzügen. Im dargestellten Ausführungsbeispiel sind diese Werkstücke W schachtelförmig ausgebildet und in einer Anzahl von jeweils vier Stück paarweise einander gegenüberliegend auf einem Werkstückträger Wt angeordnet und durch obere und untere elastische Halte-Klammern HK befestigt. Dabei werden die Werkstückträger Wt mit den Werkstücken W in einer in FIG 1 nicht dargestellten offenen Transportstrecke vor der Behandlungskammer B in eine insgesamt mit T bezeichnete Transporteinrichtung eingelegt. Das Einlegen kann manuell oder durch ein automatisches Beladegerät vorgenommen werden.

Die Transporteinrichtung T umfaßt beidseitig des Transportweges angeordnete und in Transportrichtung H hin- und herbewegbare Transportstangen Ts und auf diesen Transportstangen Ts angeordnete Mitnehmer M. Diese exzentrisch auf den drehbaren Transportstangen Ts angeordneten Mitnehmer M erfassen in der dargestellten, vertikal nach oben gerichteten Stellung die zylindrischen Enden der Werkstückträger Wt. Werden die Transportstangen Ts um 180° gedreht, so geben die Mitnehmern M die Werkstückträger Wt frei. Die für die Transporteinrichtung T wesentlichen Bewegungsabläufe sind durch Pfeile Pf1 bis Pf3 aufgezeigt, wobei die Pfeile Pf1 den taktweisen Transport der Werkstückträger Wt durch die Ätzlinie nach der sogenannten "Step and Repeat"-Methode andeuten. Die Pfeile Pf2 zeigen die Hin- und Herbewegung der Transportstangen Ts, die beispielsweise über in der Zeichnung nicht dargestellte pneumatische Stellzylinder vorgenommen wird. Die Pfeile Pf3 zeigen die Drehung von Transportstangen Ts und Mitnehmern M zum Erfassen bzw. zum Freigeben der einzelnen Werkstückträger Wt.

Innerhalb der als Ätzkammer ausgebildeten Behandlungskammer B befinden sich Düsenstöcke D zum Besprühen der Werkstücke W mit einer Flüssigkeit F, bei welcher es sich hier um eine ammoniakalische Ätzlösung handelt. Die mit Flachstrahldüsen Fd bestückten Düsenstöcke D sind horizontal und quer zur Transportrichtung H ausgerichtet. Die Düsenstöcke D sind in paarweise angeordneten Rollen Ro geführt, so daß sie eine schnelle oszillierende Längsbewegung ausführen können, die durch einen Pfeil OL angedeutet ist. Diese oszillierende Längsbewegung OL kann gegebenenfalls mit einer oszillierenden Schwenkbewegung kombiniert werden, die durch einen Pfeil OS angedeutet ist.

Zur Erzeugung der oszillierenden Längsbewegung OL sind die Düsenstöcke D an einem Düsenstock-Träger DT befestigt, dessen Verzahnung Vz mit einem Ritzel R und einer fest angeordneten Zahnstange Zs zusammenwirkt. Wird nun das Ritzel R über einen in der Zeichnung nicht dargestellten pneumatischen Stellzylinder in Richtung des Doppelpfeiles Pf4 hin- und herbewegt, so ergibt sich eine Hin- und Herbewegung der Düsenstöcke D mit doppelter Geschwindigkeit und doppeltem Hub.

Im Gegensatz zu der in FIG 1 dargestellten Lage werden die Werkstücke W beim Ätzvorgang durch Drehung des Werkstückträgers Wt um 90° vertikal angeordnet, um einen besseren Austausch der Ätzlösung und eine gleichmäßige Sprühintensität zu erzielen. Nach dem Ätzvorgang werden die Werkstücke W über den Werkstückträger Wt in die dargestellte horizontale Lage gedreht, so daß sie problemlos durch Schiebetüren St hindurch in die anschliessende Behandlungskammer B1 transportiert werden können. Die Öffnungs- und Schließbewegung der Schiebetüren St ist durch Doppelpfeile Pf5 aufgezeigt.

Um eine Verschleppung der Ätzlösung in die anschließende Behandlungskammer B1 zu verhindern, werden die Werkstücke W um die horizontal und quer zur Transportrichtung H ausgerichtete Achse A der Werkstückträger Wt gedreht, so daß die Ätzlösung ablaufen kann. Diese Drehung ist durch einen Doppelpfeil Pf6 aufgezeigt. Übertragen wird die Drehung Pf6 über eine Gelenkwelle Gw, an deren Ende ein gesondertes Führungsteil Ft der beidseitig des Transportweges angeordneten U-förmigen Führung U für die Werkstückträger Wt befestigt ist. Dieses Führungsteil Ft nimmt die Werkstückträger Wt über einen Querzapfen Q mit.

Nach dem Ablaufen der Ätzlösung durch die vorstehend beschriebene Drehung Pf6 werden die noch verbliebenen Flüssigkeitsreste durch eine Schleuderbewegung und/oder eine Schlagbewegung entfernt. Die Schleuderbewegung kann durch eine entsprechend schnelle Drehung Pf6 der Werkstückträger Wt bewirkt werden. Die Schlagbewegung wird durch beidseitig des Transportweges angeordnete Klopfeinrichtungen K bewirkt, deren Prinzip aus FIG 2 hervorgeht. Es ist zu erkennen, daß die Klopfeinrichtungen K jeweils durch das bereits erwähnte Führungsteil Ft für die Werkstückträger Wt und einen auf das Führungsteil Ft einwirkenden Nocken N gebildet sind. Der Nocken N hebt das Führungsteil Ft und damit auch den Werkstückträger Wt an und läßt ihn dann schlagartig wieder herunterfallen. Diese Schlagbewegung ist in FIG 1 durch einen Doppelpfeil Pf7 aufgezeigt. Durch die geschilderte Schlagbewegung Pf7, die gemäß FIG 2 durch die Kraft einer dem Nocken N gegenüberliegenden Feder F noch verstärkt werden kann, werden auf den Werkstücken W verbliebene Flüssigkeitsreste abgeschleudert, so daß sich allenfalls nur noch eine geringe Verschleppung der Flüssigkeit F bzw. im geschilderten Fall der Ätzlösung ergibt.

Die an die Behandlungskammer B anschließende Behandlungskammer B1 wird - wie bereits erwähnt wurde - zum Spülen der Werkstücke W eingesetzt. Die Behandlungskammer B weist einen ähnlichen Aufbau wie die Behandlungskammer B1 auf, wobei jedoch die Anordnung von fest installierten Düsenstöcken und Sprühdüsen hier einen geringeren Aufwand erfordert. Die Verschleppung von Spüllösung für auch hier auf die beschriebene Weise durch eine Schleuder- und/oder Schlagbewegung bewerkstelligt.

**Patentansprüche**

1. Vorrichtung zum Behandeln von dreidimensionalen Werkstücken (W) mit einer Flüssigkeit (F), insbesondere zum Ätzen von dreidimensionalen Spritzgießteilen mit integrierten Leiterzügen, mit
   - mindestens einer Behandlungskammer (B), welche mit Düsenstöcken (D) zum Besprühen der Werkstücke (W) mit der Flüssigkeit (F) bestückt ist,
   - Werkstückträgern (Wt) zur Aufnahme mindestens eines Werkstücks (W) und mit
   - einer Transporteinrichtung (T) zum taktweisen Transport der Werkstückträger (Wt) in und durch die Behandlungskammer (B) in einer horizontalen Transportrichtung (H), wobei
   - die Werkstückträger (Wt) zum Ablauf der Flüssigkeit (F) von den Werkstücken (W) um eine horizontal und quer zur Transportrichtung (H) ausgerichtete Achse (A) drehbar und zum Abschleudern auf den Werkstücken (W) verbliebener Flüssigkeitsreste mit einer Scheuder- und/oder Schlagbewegung beaufschlagbar sind.

2. Vorrichtung nach Anspruch 1, **dadurch gekennzeichnet,** daß die Transporteinrichtung (T) beidseitig des Transportweges angeordnete und in Transportrichtung (H) hin- und herbewegbare Transportstangen (Ts) und auf den Transportstangen (Ts) angeordnete Mitnehmer (M) für die Werkstückträger (Wt) umfaßt.

3. Vorrichtung nach Anspruch 1 oder 2, **dadurch gekennzeichnet,** daß die Behandlungskammer (B) ein- und austrittsseitig durch Schiebe- oder Schwenktüren (St) verschließbar ist.

4. Vorrichtung nach einem der vorhergehenden Ansprüche, **gekennzeichnet durch** eine Schleuderbewegung um die Achse (A) der Werkstückträger (Wt).

5. Vorrichtung nach einem der vorhergehenden Ansprüche, **dadurch gekennzeichnet,** daß die Werkstückträger (Wt) durch beidseitig des Transportweges angeordnete Klopfeinrichtungen (K) mit der Schlagbewegung beaufschlagbar sind.

6. Vorrichtung nach Anspruch 5, **dadurch gekennzeichnet,** daß die Klopfeinrichtungen (K) jeweils durch ein Führungsteil (Ft) für den Werkstückträger (Wt) und einen auf das Führungsteil (Ft) einwirkenden Nocken (N) gebildet sind.

7. Vorrichtung nach Anspruch 6, **dadurch gekennzeichnet,** daß das Führungsteil (Ft) durch den Nocken (N) gegen die Kraft einer Feder (F) anhebbar ist.

8. Vorrichtung nach Anspruch 6 oder 7, **dadurch gekennzeichnet,** daß eines der Führungsteile (Ft) als Mitnehmer für die Drehung des Werkstückträgers (Wt) ausgebildet ist.

9. Vorrichtung nach einem der vorhergehenden Ansprüche, **dadurch gekennzeichnet,** daß die Düsenstöcke (D) horizontal und quer zur Transportrichtung (H) ausgerichtet sind.

10. Vorrichtung nach Anspruch 9, **dadurch gekennzeichnet,** daß die Düsenstöcke (D) eine oszillierende Längsbewegung (OL) und/oder eine oszillierende Schwenkbewegung (OS) um ihre Längsachse ausführen.

**FIG 1**

**FIG2**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | WO-A-8 911 779 (HANS HÖLLMÜLLER MASCHINENBAU GmbH) <br> * Seite 2, Zeilen 21-31; Amspruch 1; Figuren 1,2 * <br> — — — | 1 | C 23 F 1/08 <br> H 05 K 3/06 |
| A | WO-A-8 911 777 (HANS HÖLLMÜLLER MASCHINENBAU GmbH) <br> — — — | | |
| A | DE-A-2 651 429 (PHILIPS PATENTVERWALTUNG GmbH) <br> — — — — | | |

| RECHERCHIERTE SACHGEBIETE (Int. Cl.5) |
|---|
| H 05 K <br> C 23 F |

Der vorliegende Recherchenbericht wurde für alle Patentansprüche erstellt

| Recherchenort | Abschlußdatum der Recherche | Prüfer |
|---|---|---|
| Den Haag | 25 Januar 91 | PUHL A.T. |